# EUROPEAN PATENT APPLICATION

(11) **EP 4 156 246 A1**
(43) Date of publication of application: **29.03.2023**
(21) Application number: 22182990.6
(22) Date of filing: 05.07.2022
(51) Int. Cl.: H01L 21/8256, H01L 27/06, H01L 27/092, H01L 29/775, H01L 27/12, H01L 21/8238

(54) **THIN FILM TRANSISTORS HAVING CMOS FUNCTIONALITY INTEGRATED WITH 2D CHANNEL MATERIALS**

(30) Priority: 24.09.2021 US 202117485185
(71) Applicant: INTEL Corporation, Santa Clara, CA 95054 (US)
(72) Inventor: O'Brien, Kevin, Portland, 97209 (US); Dorow, Chelsey, Portland, 97205 (US); Naylor, Carl, Portland, 97229 (US); Maxey, Kirby, Hillsboro, 97124 (US); Lee, Sudarat, Hillsboro, 97124 (US); Penumatcha, Ashish Verma, Beaverton, 97003 (US); Avci, Uygar E., Portland, 97225 (US); Clendenning, Scott, Portland, 97225 (US); Alaan, Urusa, Hillsboro, 97124 (US); Tronic, Tristan, Aloha, 97003 (US)
(74) Representative: Goddar, Heinz J.

(57) **Abstract**

Thin film transistors having CMOS functionality integrated with two-dimensional (2D) channel materials are described. In an example, an integrated circuit structure includes a first device including a first two-dimensional (2D) material layer, and a first gate stack around the first 2D material layer. The first gate stack has a gate electrode around a gate dielectric layer. A second device is stacked on the first device. The second device includes a second 2D material layer, and a second gate stack around the second 2D material layer. The second gate stack has a gate electrode around a gate dielectric layer. The second 2D material layer has a composition different than a composition of the first 2D material layer.

## Description

### TECHNICAL FIELD

Embodiments of the disclosure are in the field of integrated circuit structures and, in particular, thin film transistors having CMOS functionality integrated with two-dimensional (2D) channel materials.

### BACKGROUND

For the past several decades, the scaling of features in integrated circuits has been a driving force behind an ever-growing semiconductor industry. Scaling to smaller and smaller features enables increased densities of functional units on the limited real estate of semiconductor chips.

For example, shrinking transistor size allows for the incorporation of an increased number of memory or logic devices on a chip, lending to the fabrication of products with increased capacity. The drive for ever-more capacity, however, is not without issue. The necessity to optimize the performance of each device becomes increasingly significant. In the manufacture of integrated circuit devices, multi-gate transistors, such as tri-gate transistors, have become more prevalent as device dimensions continue to scale down. In conventional processes, tri-gate transistors are generally fabricated on either bulk silicon substrates or silicon-on-insulator substrates. In some instances, bulk silicon substrates are preferred due to their lower cost and compatibility with the existing high-yielding bulk silicon substrate infrastructure. Scaling multi-gate transistors has not been without consequence, however. As the dimensions of these fundamental building blocks of microelectronic circuitry are reduced and as the sheer number of fundamental building blocks fabricated in a given region is increased, the constraints on the semiconductor processes used to fabricate these building blocks have become overwhelming.

The performance of a thin-film transistor (TFT) may depend on a number of factors. For example, the efficiency at which a TFT is able to operate may depend on the sub threshold swing of the TFT, characterizing the amount of change in the gate-source voltage needed to achieve a given change in the drain current. A smaller sub threshold swing enables the TFT to turn off to a lower leakage value when the gate-source voltage drops below the threshold voltage of the TFT. The conventional theoretical lower limit at room temperature for the sub threshold swing of the TFT is 60 millivolts per decade of change in the drain current.

Variability in conventional and state-of-the-art fabrication processes may limit the possibility to further extend them into the, e.g., 13 nm or sub-13 nm range. Consequently, fabrication of the functional components needed for future technology nodes may require the introduction of new methodologies or the integration of new technologies in current fabrication processes or in place of current fabrication processes.

### BRIEF DESCRIPTION OF THE DRAWINGS

Figure 1 illustrates a cross-sectional view of an integrated circuit structure having CMOS functionality integrated with a two-dimensional (2D) channel material, in accordance with an embodiment of the present disclosure.
Figures 2A-2G illustrate cross-sectional views representing various operations in a method of fabricating an integrated circuit structure having CMOS functionality integrated with a two-dimensional (2D) channel material, in accordance with an embodiment of the present disclosure.
Figures 3A-3E illustrate cross-sectional views representing various operations in another method of fabricating an integrated circuit structure having CMOS functionality integrated with a two-dimensional (2D) channel material, in accordance with another embodiment of the present disclosure.
Figures 4 and 5 are top views of a wafer and dies that include one or more thin film transistors having CMOS functionality integrated with two-dimensional (2D) channel materials, in accordance with one or more of the embodiments disclosed herein.
Figure 6 is a cross-sectional side view of an integrated circuit (IC) device that may include one or more thin film transistors having CMOS functionality integrated with two-dimensional (2D) channel materials, in accordance with one or more of the embodiments disclosed herein.
Figure 7 is a cross-sectional side view of an integrated circuit (IC) device assembly that may include one or more thin film transistors having CMOS functionality integrated with two-dimensional (2D) channel materials, in accordance with one or more of the embodiments disclosed herein.
Figure 8 illustrates a computing device in accordance with one implementation of an embodiment of the disclosure.

### DESCRIPTION OF THE EMBODIMENTS

Thin film transistors having CMOS functionality integrated with two-dimensional (2D) channel materials are described. In the following description, numerous specific details are set forth, such as specific material and tooling regimes, in order to provide a thorough understanding of embodiments of the present disclosure. It will be apparent to one skilled in the art that embodiments of the present disclosure may be practiced without these specific details. In other instances, well-known features, such as single or dual damascene processing, are not described in detail in order to not unnecessarily obscure embodiments of the present disclosure. Furthermore, it is to be understood that the various embodiments shown in the Figures are illustrative representations and are not necessarily drawn to scale. In some cases, various operations will be described as multiple discrete operations, in turn, in a manner that is most helpful in understanding the present disclosure, however, the order of description should not be construed to imply that these operations are necessarily order dependent. In particular, these operations need not be performed in the order of presentation.

Certain terminology may also be used in the following description for the purpose of reference only, and thus are not intended to be limiting. For example, terms such as "upper", "lower", "above", "below," "bottom," and "top" refer to directions in the drawings to which reference is made. Terms such as "front", "back", "rear", and "side" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

Embodiments described herein may be directed to front-end-of-line (FEOL) semiconductor processing and structures. FEOL is the first portion of integrated circuit (IC) fabrication where the individual devices (e.g., transistors, capacitors, resistors, etc.) are patterned in the semiconductor substrate or layer. FEOL generally covers everything up to (but not including) the deposition of metal interconnect layers. Following the last FEOL operation, the result is typically a wafer with isolated transistors (e.g., without any wires).

Embodiments described herein may be directed to back-end-of-line (BEOL) semiconductor processing and structures. BEOL is the second portion of IC fabrication where the individual devices (e.g., transistors, capacitors, resistors, etc.) are interconnected with wiring on the wafer, e.g., the metallization layer or layers. BEOL includes contacts, insulating layers (dielectrics), metal levels, and bonding sites for chip-to-package connections. In the BEOL part of the fabrication stage contacts (pads), interconnect wires, vias and dielectric structures are formed. For modern IC processes, more than 10 metal layers may be added in the BEOL.

Embodiments described below may be applicable to FEOL processing and structures, BEOL processing and structures, or both FEOL and BEOL processing and structures. In particular, although an exemplary processing scheme may be illustrated using a FEOL processing scenario, such approaches may also be applicable to BEOL processing. Likewise, although an exemplary processing scheme may be illustrated using a BEOL processing scenario, such approaches may also be applicable to FEOL processing.

One or more embodiments described herein are directed to two-dimensional (2D) transition metal dichalcogenide (TMD) stacked structures for CMOS. Embodiments may include the use of side contacts. Embodiments may include or pertain to one or more of front end transistors, back end transistors, thin film transistors, or system-on-chip (SoC) technologies.

To provide context, silicon (Si) cannot scale lower than 13nm gate length (Lg) due to electrostatics and mobility reduction. However, 2D TMD field effect transistors can scale lower than 13nm gate length (Lg). As such stacked Si nanowires can be limited to Lg larger than 13nm.

In accordance with one or more embodiment of the present disclosure, process integration of 2D TMD in a stacked NMOS over PMOS or PMOS over NMOS arrangement is described. Embodiments described herein can be implemented to enable facial integration of stacked CMOS with 2D TMD, e.g., enabling a continuation of Moore's Law.

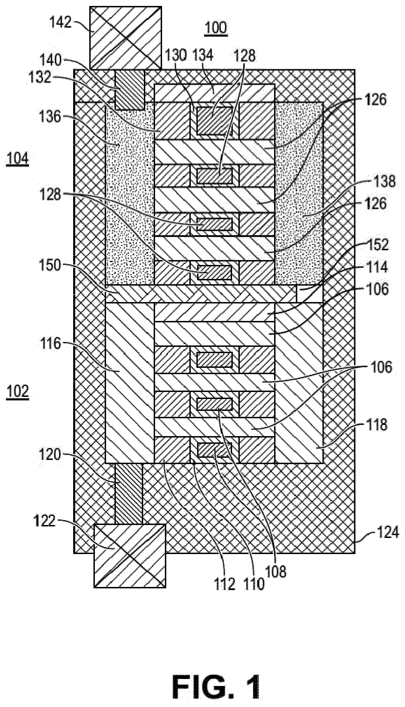

As an exemplary structure, Figure 1 illustrates a cross-sectional view of an integrated circuit structure having CMOS functionality integrated with a two-dimensional (2D) channel material, in accordance with an embodiment of the present disclosure.

Referring to Figure 1, an integrated circuit structure 100 includes a first device 102, such as an NMOS device. A second device 104, such as a PMOS device, is stacked on the first device 102.

The first device 102 includes a first plurality of vertically stacked two-dimensional (2D) material layers 106, such as MoS₂ layers. A first gate stack 108/110 is around the first plurality of vertically stacked 2D material layers 106. The first gate stack 108/110 has a gate electrode 108, such as a metal gate electrode, around a gate dielectric layer 110, such as a high-k gate dielectric layer. First gate spacers 112, such as boron nitride spacers or carbon-doped oxide spacers, are along sides of the first gate stack 108/110. A dielectric cap 114, such as a silicon carbide cap, is on a top one of the first plurality of vertically stacked 2D material layers 106. Source or drain contacts 116/118 are along sides of the first plurality of vertically stacked 2D material layers 106. The source or drain contact 116 can be coupled to a lower power rail 122 by a conductive via 120, such as is depicted.

The second device 104 includes a second plurality of vertically stacked two-dimensional (2D) material layers 126, such as WSe₂ layers. A second gate stack 128/130 is around the second plurality of vertically stacked 2D material layers 126. The second gate stack 128/130 has a gate electrode 128, such as a metal gate electrode, around a gate dielectric layer 130, such as a high-k gate dielectric layer. Second gate spacers 132, such as boron nitride spacers or carbon-doped oxide spacers, are along sides of the second gate stack 128/130. A dielectric cap 134, such as a silicon carbide cap, is on a top one of the second plurality of vertically stacked 2D material layers 126. Source or drain contacts 136/138 are along sides of the second plurality of vertically stacked 2D material layers 126. The source or drain contact 136 can be coupled to a lower power rail 142 by a conductive via 140, such as is depicted, e.g., which may be fabricated during a backside reveal process.

The first device 102 and the second device 104 can be surrounded by a dielectric framework 124, such as a silicon nitride framework. For simplicity, a single dielectric framework 124 is depicted. However, each device 102 and 104 may have its own associated separate and distinct dielectric framework. In an embodiment, the first device 102 and the second device 104 are vertically separated by a break layer 150, such as a layer of amorphous boron nitride. In an embodiment, a conductive connection layer 152, such as a tungsten via or cobalt via, electrically couples the first device 102 and the second device 104 through the break layer 150, e.g., to provide an inverter structure. In another embodiment, the break layer 150 entirely electrically isolates the first device 102 from the second device 104.

With reference again to Figure 1, in accordance with an embodiment of the present disclosure, an integrated circuit structure 100 includes a first device 102 including a first two-dimensional (2D) material layer 106, and a first gate stack 108/110 around the first 2D material layer 106. The first gate stack 108/110 has a gate electrode 108 around a gate dielectric layer 110. A second device 104 is stacked on the first device 102. The second device 104 includes a second 2D material layer 126, and a second gate stack 128/130 around the second 2D material layer 126. The second gate stack 128/130 has a gate electrode 128 around a gate dielectric layer 130. The second 2D material layer 126 has a composition different than a composition of the first 2D material layer 106.

In an embodiment, the first device 102 is an NMOS device, and the second device 104 is a PMOS device. In another embodiment, the first device 102 is a PMOS device, and the second device 104 is an NMOS device. In another embodiment, the first device 102 is a first PMOS device, and the second device 104 is a second PMOS device. In another embodiment, the first device 102 is a first NMOS device, and the second device 104 is a second NMOS device.

In an embodiment, the first device 102 is electrically coupled to the second device 104, as is depicted. In another embodiment, the first device 102 is electrically isolated from the second device 104.

With reference again to Figure 1, in accordance with another embodiment of the present disclosure, an integrated circuit structure 100 includes an NMOS device 102 including a first plurality of vertically stacked two-dimensional (2D) material layers 106, each of the first plurality of vertically stacked 2D material layers 106 including molybdenum and sulfur. A first gate stack 108/110 is around the first plurality of vertically stacked 2D material layers 106, the first gate stack 108/110 having a gate electrode 108 around a gate dielectric layer 110. A PMOS device 104 is stacked on the NMOS device 102. The PMOS device 104 includes a second plurality of vertically stacked 2D material layers 126, each of the second plurality of vertically stacked 2D material layers 126 including tungsten and selenium. A second gate stack 128/130 is around the second plurality of vertically stacked 2D material layers 126, the second gate stack 128/130 having a gate electrode 128 around a gate dielectric layer 130.

In an embodiment, the NMOS device 102 is electrically coupled to the PMOS device 104. In another embodiment, the NMOS device 102 is electrically isolated from the PMOS device 104.

In an embodiment, the first plurality of vertically stacked 2D material layers 106 is a first plurality of vertically stacked nanosheets, and the second plurality of vertically stacked 2D material layers 126 is a second plurality of vertically stacked nanosheets. In another embodiment, the first plurality of vertically stacked 2D material layers 106 is a first plurality of vertically stacked nanowires, and the second plurality of vertically stacked 2D material layers 126 is a second plurality of vertically stacked nanowires.

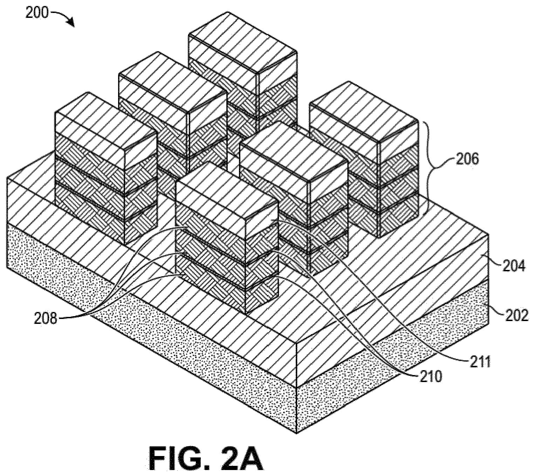

As an exemplary processing scheme, Figures 2A-2G illustrate cross-sectional views representing various operations in a method of fabricating an integrated circuit structure having CMOS functionality integrated with a two-dimensional (2D) channel material, in accordance with an embodiment of the present disclosure.

Referring to Figure 2A, a starting structure 200 includes an insulator layer 204, such as a silicon carbide layer, on a substrate 202, such as a silicon substrate. A plurality of device precursor stacks 206 are formed on the insulator layer 204, e.g., by various deposition, patterning, and etch processes. Each of the device precursor stacks 206 includes a plurality of alternating sacrificial layers 208, such as silicon oxide layers, and two-dimensional (2D) material layers 210. The spacing between vertically adjacent 2D material layers 210 can be the same, as is depicted, or can be varied. Each of the device precursor stacks 206 can further include a dielectric cap 211, such as a silicon carbide cap.

In an embodiment, the 2D material layers 210 are composed of a material such as molybdenum sulfide (MoS₂), tungsten sulfide (WS₂), molybdenum selenide (MoSe₂), tungsten selenide (WSe₂), molybdenum telluride (MoTe₂), or indium selenide (InSe). In an embodiment, the 2D material layer 210 has a thickness in a range of 0.6 - 5 nanometers. In an embodiment, each 2D material layer 210 has a nanosheet structure or nanoribbon structure (e.g., a greater short horizontal dimension than vertical dimension), as is depicted. In another embodiment, each 2D material layer 210 has a nanowire structure (e.g., about the same vertical dimension as the short horizontal dimension).

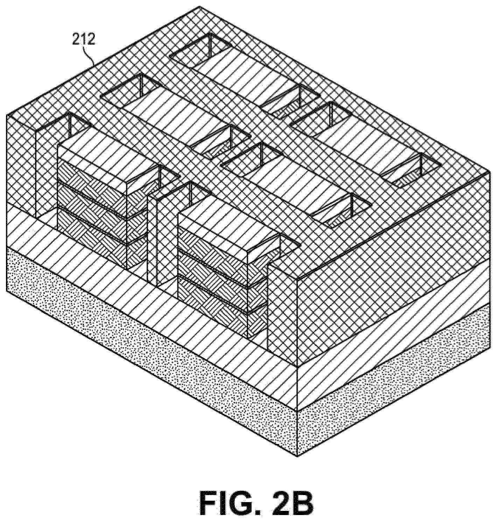

Referring to Figure 2B, a dielectric framework 212, such as a silicon nitride framework, is formed on the structure of Figure 2A. In one embodiment, the dielectric framework 212 includes cavities therein, as is depicted, e.g., to accommodate eventual source or drain structures.

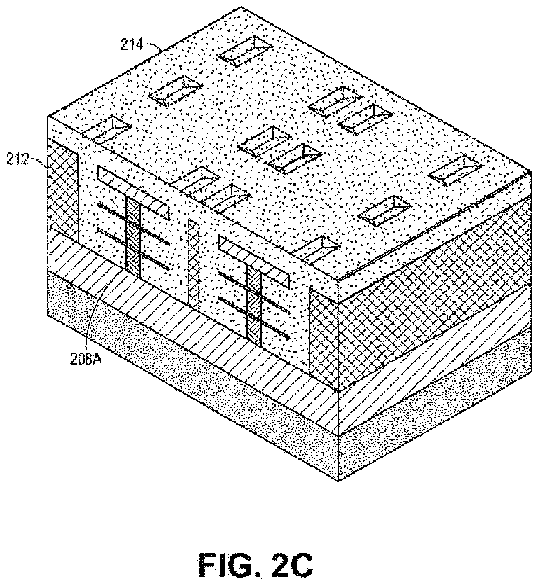

Referring to Figure 2C, the sacrificial layers 208 are laterally recessed to form recessed sacrificial layers 208A, e.g., by a selective wet etch process. A fill material 214 is then formed over the resulting structure. In one embodiment, the fill material 214 is or includes amorphous boron nitride. In another embodiment, the fill material 214 is or includes a carbon-doped oxide material.

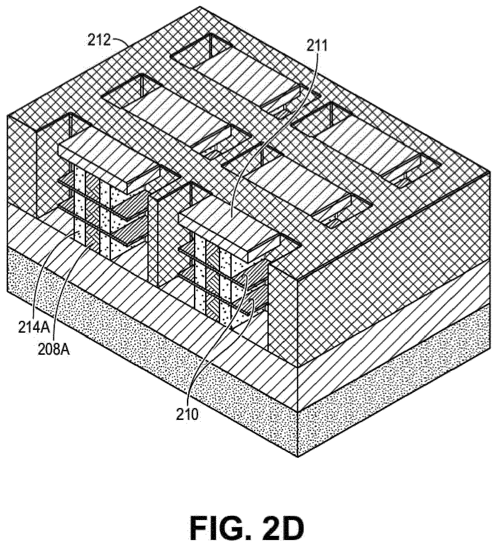

Referring to Figure 2D, the fill material is etched and recessed to provide recessed fill material 214A along sides of the recessed sacrificial layers 208A. In one embodiments, the recessed fill material 214A is ultimately retained as gate spacers in a final device. In one embodiment, the 2D material layers 210 extend laterally beyond the recessed fill material 214A, as is depicted.

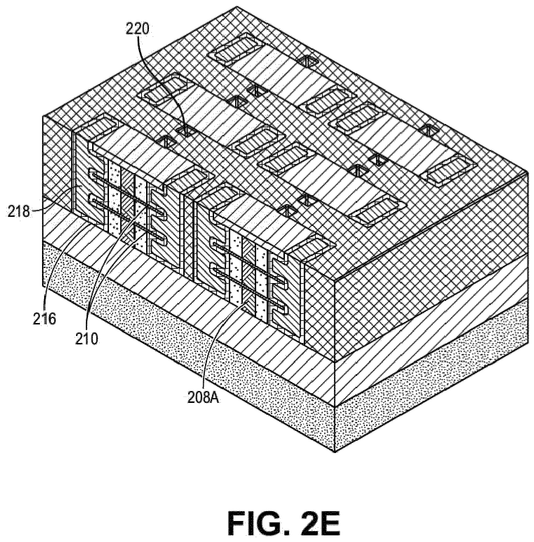

Referring to Figure 2E, conductive contact structures 216/218 are formed adjacent to the recessed fill material 214A, and on the portions of the 2D material layers 210 that extend laterally beyond the recessed fill material 214A. In an embodiment, the conductive contact structures 216/218 are source or drain contact structures. In one embodiment, the conductive contact structures 216/218 include a liner layer 216 and a conductive fill 218, as is depicted. In a particular such embodiment, the liner layer 216 is or includes antimony (Sb), bismuth (Bi) or ruthernium (Ru), or an ally including one or more of Sb, Bi or Ru. In one embodiment, the conductive fill 218 is or includes cobalt (Co), tungsten (W), copper (Cu), or gold (Au). Following the formation of conductive contact structures 216/218, openings 220 may be made through the dielectric framework 212, e.g., to expose sides of the structure for a replacement gate process.

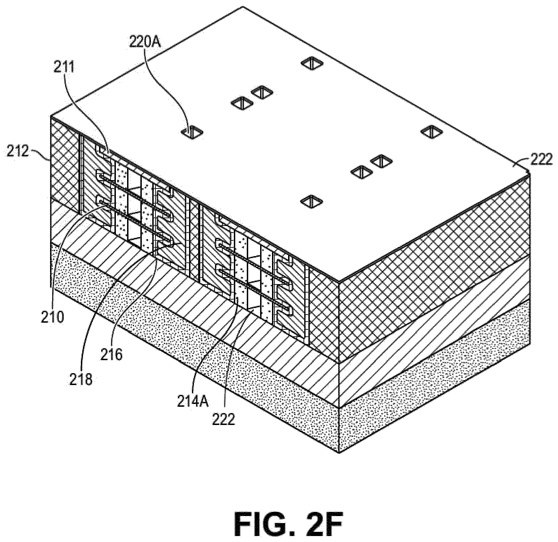

Referring to Figure 2F, the recessed sacrificial layers 208A are removed, e.g., by a wet etch process performed through openings 220. A gate dielectric layer 222 is then formed, e.g., through and in openings 220 to form a gate dielectric on portions of the 2D material layers 210 exposed upon removal of the recessed sacrificial layers 208A. The material of the gate dielectric layer 222 may also form lined openings 220A, as is depicted.

In an embodiment, the gate dielectric layer 222 is a high-k dielectric layer formed by an atomic layer deposition (ALD) process. In an embodiment, the gate dielectric layer 222 includes a dielectric material selected from the group consisting of hafnium oxide, zirconium oxide, hafnium aluminum oxide, zirconium hafnium oxide, and strontium titanium oxide.

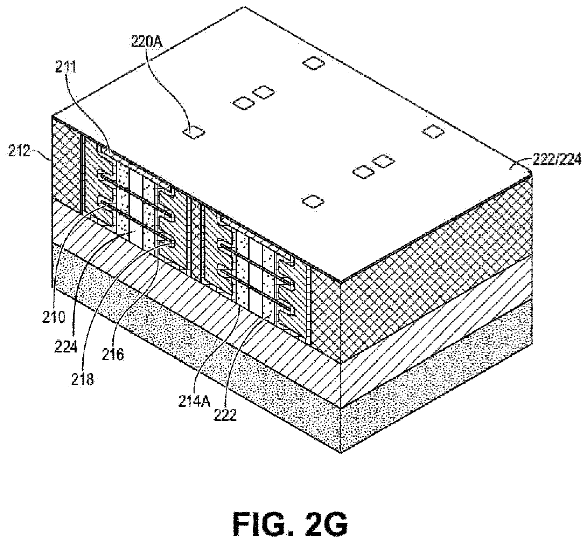

Referring to Figure 2G, a gate electrode 224 is formed on the structure of Figure 2F, e.g., through and in openings 220A to form a gate electrode on the gate dielectric 222 formed on portions of the 2D material layers 210 exposed upon removal of the recessed sacrificial layers 208A. The material of the gate electrode 224 may also fill the lined openings 220A. The portions of the gate electrode 224 and the gate dielectric 222 above the dielectric cap 211 can then be removed, e.g., by a planarization process to re-expose the dielectric cap 211. In the case that gate electrode material remains in the openings 220, the resulting structures may be used to act as a gate contact.

In an embodiment, the resulting the device or layer of devices of the process of Figures 2A-2G can be used to fabricate a stacked device or stacked device layer structure. In one embodiment, the resulting the device or layer of devices can be used as a device 102 in the structure described in association with Figure 1, e.g., a second device or device layer may be fabricated thereon. In another embodiment, the resulting the device or layer of devices can be used as a device 104 in the structure described in association with Figure 1, e.g., the structure is fabricated on a first device or device layer there under.

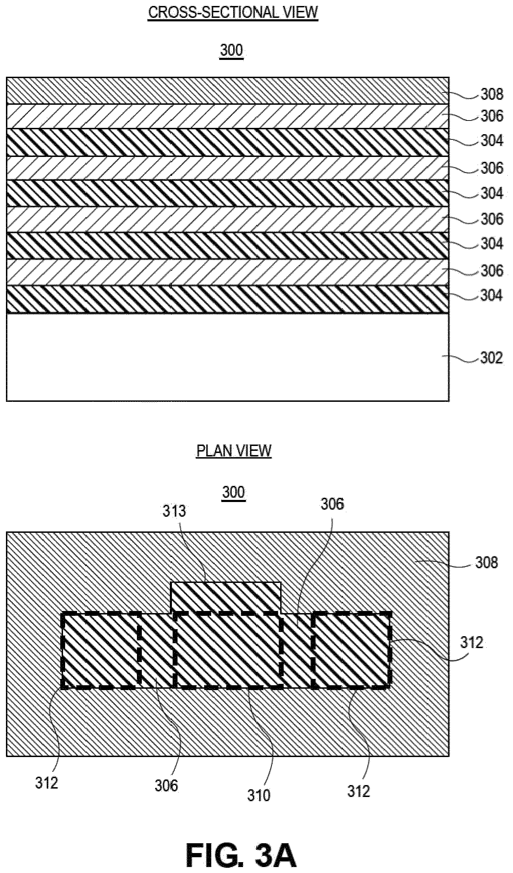

In a second exemplary processing scheme, Figures 3A-3E illustrate cross-sectional views representing various operations in another method of fabricating an integrated circuit structure having CMOS functionality integrated with a two-dimensional (2D) channel material, in accordance with another embodiment of the present disclosure.

Referring to Figure 3A, a starting structure 300 includes a dielectric superlattice of alternating first 304 and second 306 dielectric layers on a foundation layer 302, such as a patterned silicon layer. The alternating first 304 and second 306 dielectric layers can be, e.g., alternating AIN/GaN layers, or alternating oxide/nitride layers. A field oxide layer 308 may be formed on the superlattice of alternating first 304 and second 306 dielectric layers, as is depicted. The stack can include a channel region 310, source or drain regions 312, and a gate region 313.

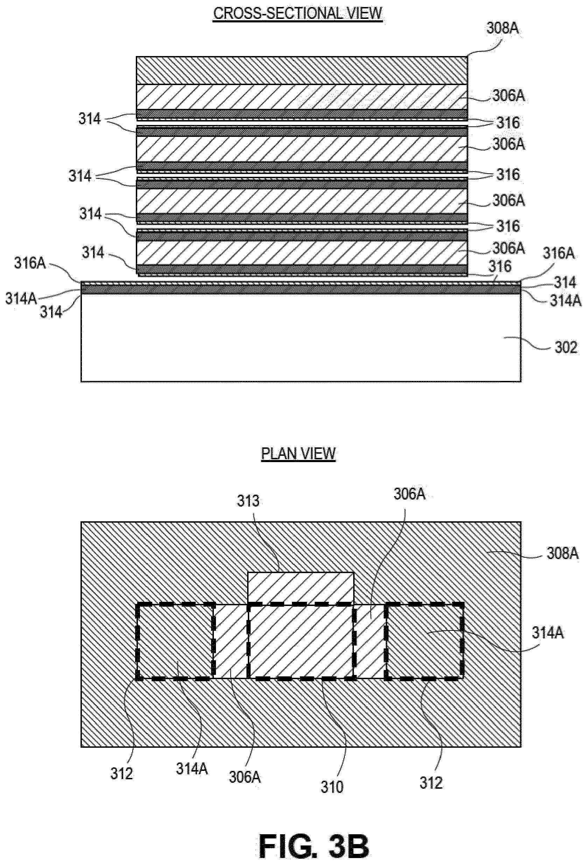

Referring to Figure 3B, the stack of Figure 3A is patterned and the first dielectric layers 304 are removed to leave patterned second dielectric layers 306A and patterned field oxide layer 308A. A 2D material 314 including a lower wider portion 314A, such as molybdenum sulfide (MoS₂), tungsten sulfide (WS₂), molybdenum selenide (MoSe₂), tungsten selenide (WSe₂), or indium selenide (InSe), is then formed. A first gate dielectric 316 including a lower wider portion 316A, such as a high-k gate dielectric, is then formed.

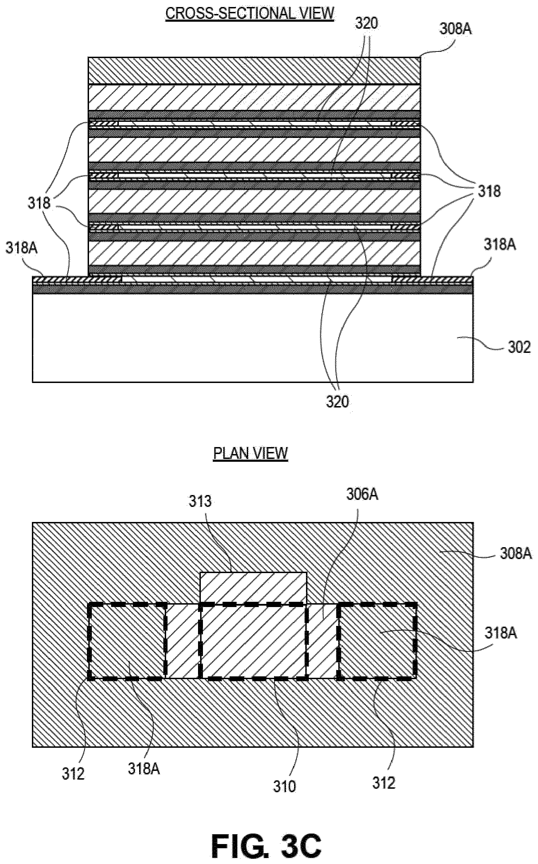

Referring to Figure 3C, gate electrodes 320, such as metal layer or metal-containing layers, are formed within the structure of Figure 3B. Dielectric spacers 318 including a lower wider portion 318A, such as low-k dielectric spacers are then formed as caps to the gate electrodes 320.

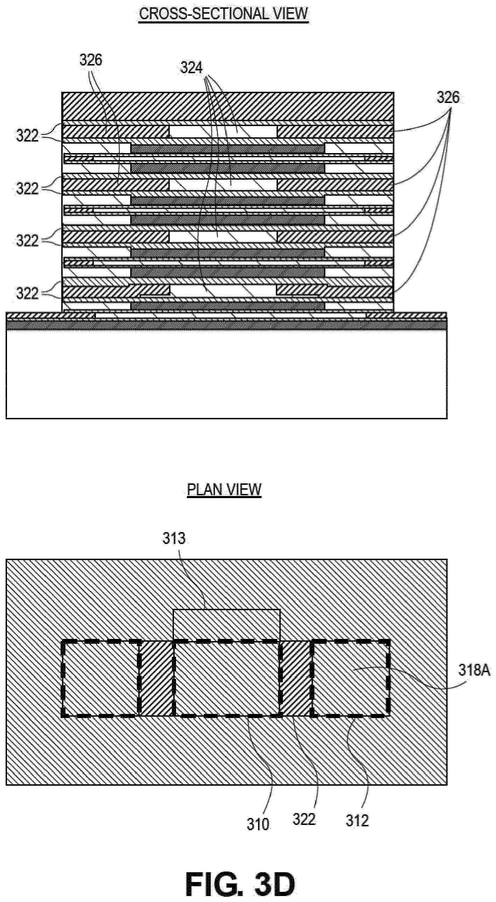

Referring to Figure 3D, patterned second dielectric layers 306A are removed. A second gate dielectric 322, such as a high-k gate dielectric, is then formed. Gate electrodes 324, such as metal layer or metal-containing layers, are formed within the structure of Figure 3C. Dielectric spacers 326, such as low-k dielectric spacers are then formed as caps to the gate electrodes 324. In an embodiment, gate electrodes 320 extend laterally further than gate electrodes 324, as is depicted.

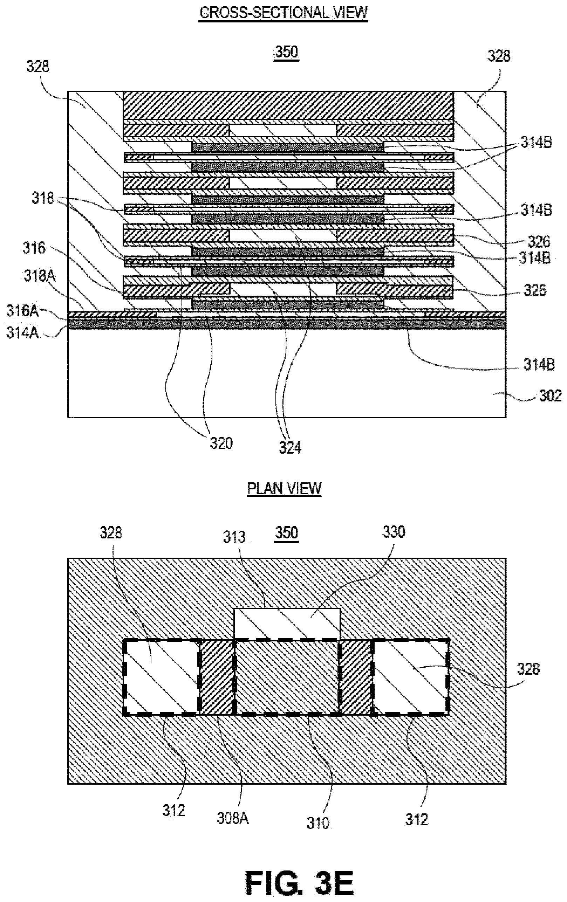

Referring to Figure 3E, an integrated circuit structure 350 is formed upon performing a timed recess of the 2D material 314 to form recessed 2D material 314B, followed by contact fill to form source or drain contacts 328 and gate contact 330. In an embodiment, the gate electrodes 320 extend beneath the source or drain contacts 328, which may ultimately reduce contact resistance. In an embodiment, the gate electrodes 320 and 324 can be electrically coupled together, e.g., at a location into or out of the page.

In an embodiment, the resulting the device or layer of devices of the process of Figures 3A-3E can be used to fabricate a stacked device or stacked device layer structure. In one embodiment, the resulting the device or layer of devices can be used as a device 102 in the structure described in association with Figure 1, e.g., a second device or device layer may be fabricated thereon. In another embodiment, the resulting the device or layer of devices can be used as a device 104 in the structure described in association with Figure 1, e.g., the structure is fabricated on a first device or device layer there under.

It is to be appreciated that in some embodiments the layers and materials described in association with embodiments herein are typically formed on or above an underlying semiconductor substrate, e.g., as FEOL layer(s). In other embodiments, the layers and materials described in association with embodiments herein are formed on or above underlying device layer(s) of an integrated circuit, e.g., as BEOL layer(s) above an underlying semiconductor substrate. In an embodiment, an underlying semiconductor substrate represents a general workpiece object used to manufacture integrated circuits. The semiconductor substrate often includes a wafer or other piece of silicon or another semiconductor material. Suitable semiconductor substrates include, but are not limited to, single crystal silicon, polycrystalline silicon and silicon on insulator (SOI), as well as similar substrates formed of other semiconductor materials. The semiconductor substrate, depending on the stage of manufacture, often includes transistors, integrated circuitry, and the like. The substrate may also include semiconductor materials, metals, dielectrics, dopants, and other materials commonly found in semiconductor substrates. Furthermore, although not depicted, structures described herein may be fabricated on underlying lower level back-end-of-line (BEOL) interconnect layers.

In the case that an insulator layer is optionally used, the insulator layer may be composed of a material suitable to ultimately electrically isolate, or contribute to the isolation of, portions of a gate structure from an underlying bulk substrate or interconnect layer. For example, in one embodiment, the insulator layer is composed of a dielectric material such as, but not limited to, silicon dioxide, silicon oxy-nitride, silicon nitride, carbon-doped silicon nitride, aluminum oxide, or aluminum nitride. In a particular embodiment, the insulator layer is a low-k dielectric layer of an underlying BEOL layer.

In an embodiment, a channel material layer of a TFT is or includes a 2D material (e.g., MoS₂, WS₂, MoSe₂, WSe₂, MoTe₂, or InSe). The 2D material of layer can be formed together with a lower hexagonal boron nitride (hBN) layer, an upper hBN layer, or both a lower hBN layer and an upper hBN layer. In an embodiment, the channel material layer has a thickness between 0.5 nanometers and 10 nanometers.

In an embodiment, gate electrodes described herein include at least one P-type work function metal or N-type work function metal, depending on whether the integrated circuit device is to be included in a P-type transistor or an N-type transistor. For a P-type transistors, metals that may be used for the gate electrode may include, but are not limited to, ruthenium, palladium, platinum, cobalt, nickel, and conductive metal oxides (e.g., ruthenium oxide). For an N-type transistor, metals that may be used for the gate electrode include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). In some embodiments, the gate electrode includes a stack of two or more metal layers, where one or more metal layers are work function metal layers and at least one metal layer is a fill metal layer. Further metal layers may be included for other purposes, such as to act as a barrier layer. In some implementations, the gate electrode may consist of a "U"-shaped structure that includes a bottom portion substantially parallel to the surface of the substrate and two sidewall portions that are substantially perpendicular to the top surface of the substrate. In another implementation, at least one of the metal layers that form the gate electrode may simply be a planar layer that is substantially parallel to the top surface of the substrate and does not include sidewall portions substantially perpendicular to the top surface of the substrate. In further implementations of the disclosure, the gate electrode may consist of a combination of U-shaped structures and planar, non-U-shaped structures. For example, the gate electrode may consist of one or more U-shaped metal layers formed atop one or more planar, non-U-shaped layers.

In an embodiment, gate dielectric layers described herein are composed of a high-k material. For example, in one embodiment, a gate dielectric layer is composed of a material such as, but not limited to, hafnium oxide, hafnium oxy-nitride, hafnium silicate, lanthanum oxide, zirconium oxide, zirconium silicate, hafnium zirconium oxide, tantalum oxide, barium strontium titanate, barium titanate, strontium titanate, yttrium oxide, aluminum oxide, lead scandium tantalum oxide, lead zinc niobate, or a combination thereof. In some implementations, the gate dielectric may consist of a "U"-shaped structure that includes a bottom portion substantially parallel to the surface of the substrate and two sidewall portions that are substantially perpendicular to the top surface of the substrate.

In an embodiment, dielectric spacers are formed from a material such as silicon nitride, silicon oxide, silicon carbide, silicon nitride doped with carbon, silicon oxynitride, aluminum oxide, or aluminum nitride. Processes for forming sidewall spacers are well known in the art and generally include deposition and etching process steps. In some embodiments, a plurality of spacer pairs may be used. For example, two pairs, three pairs, or four pairs of sidewall spacers may be formed on opposing sides of the gate electrode.

In an embodiment, conductive contacts act as contacts to source or drain regions of a TFT, or act directly as source or drain regions of the TFT. The conductive contacts may be spaced apart by a distance that is the gate length of the transistor. In some embodiments, the gate length is between 2 and 30 nanometers. In an embodiment, the conductive contacts include one or more layers of metal and/or metal alloys.

In an embodiment, interconnect lines (and, possibly, underlying via structures), such as interconnect lines, described herein are composed of one or more metal or metal-containing conductive structures. The conductive interconnect lines are also sometimes referred to in the art as traces, wires, lines, metal, interconnect lines or simply interconnects. In a particular embodiment, each of the interconnect lines includes a barrier layer and a conductive fill material. In an embodiment, the barrier layer is composed of a metal nitride material, such as tantalum nitride or titanium nitride. In an embodiment, the conductive fill material is composed of a conductive material such as, but not limited to, Cu, Al, Ti, Zr, Hf, V, Ru, Co, Ni, Pd, Pt, W, Ag, Au or alloys thereof.

In an embodiment, ILD materials described herein are composed of or include a layer of a dielectric or insulating material. Examples of suitable dielectric materials include, but are not limited to, oxides of silicon (e.g., silicon dioxide (SiO₂)), doped oxides of silicon, fluorinated oxides of silicon, carbon doped oxides of silicon, aluminum oxide, various low-k dielectric materials known in the arts, and combinations thereof. The interlayer dielectric material may be formed by conventional techniques, such as, for example, chemical vapor deposition (CVD), physical vapor deposition (PVD), or by other deposition methods.

In one aspect, a gate electrode and gate dielectric layer, particularly upper gate stacks, may be fabricated by a replacement gate process. In such a scheme, dummy gate material such as polysilicon or silicon nitride pillar material, may be removed and replaced with permanent gate electrode material. In one such embodiment, a permanent gate dielectric layer is also formed in this process, as opposed to being carried through from earlier processing. In an embodiment, dummy gates are removed by a dry etch or wet etch process. In one embodiment, dummy gates are composed of polycrystalline silicon or amorphous silicon and are removed with a dry etch process including use of SF₆. In another embodiment, dummy gates are composed of polycrystalline silicon or amorphous silicon and are removed with a wet etch process including use of aqueous NH₄OH or tetramethylammonium hydroxide. In one embodiment, dummy gates are composed of silicon nitride and are removed with a wet etch including aqueous phosphoric acid.

In an embodiment, one or more approaches described herein contemplate essentially a dummy and replacement gate process in combination with a dummy and replacement contact process to arrive at structures described herein. In one such embodiment, the replacement contact process is performed after the replacement gate process to allow high temperature anneal of at least a portion of the permanent gate stack. For example, in a specific such embodiment, an anneal of at least a portion of the permanent gate structures, e.g., after a gate dielectric layer is formed. The anneal is performed prior to formation of the permanent contacts.

It is to be appreciated that not all aspects of the processes described above need be practiced to fall within the spirit and scope of embodiments of the present disclosure. For example, in one embodiment, dummy gates need not ever be formed prior to fabricating gate contacts over active portions of the gate stacks. The gate stacks described above may actually be permanent gate stacks as initially formed. Also, the processes described herein may be used to fabricate one or a plurality of semiconductor devices. One or more embodiments may be particularly useful for fabricating semiconductor devices at a 10 nanometer (10 nm) or smaller technology node.

In an embodiment, as is also used throughout the present description, lithographic operations are performed using 193nm immersion lithography (i193), extreme ultra-violet (EUV) and/or electron beam direct write (EBDW) lithography, or the like. A positive tone or a negative tone resist may be used. In one embodiment, a lithographic mask is a trilayer mask composed of a topographic masking portion, an anti-reflective coating (ARC) layer, and a photoresist layer. In a particular such embodiment, the topographic masking portion is a carbon hardmask (CHM) layer and the anti-reflective coating layer is a silicon ARC layer.

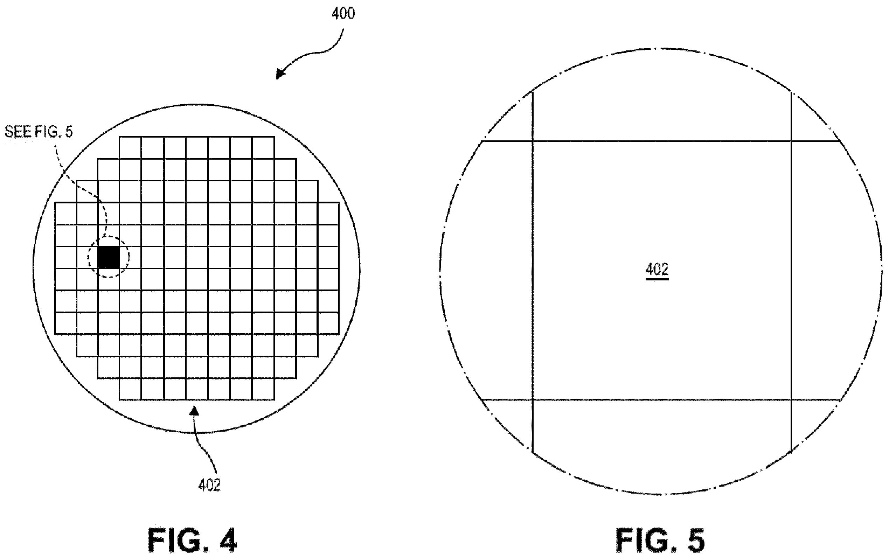

In another aspect, the integrated circuit structures described herein may be included in an electronic device. As a first example of an apparatus that may include one or more of the TFTs disclosed herein, Figures 4 and 5 are top views of a wafer and dies that include one or more thin film transistors having CMOS functionality integrated with two-dimensional (2D) channel materials, in accordance with any of the embodiments disclosed herein.

Referring to Figures 4 and 5, a wafer 400 may be composed of semiconductor material and may include one or more dies 402 having integrated circuit (IC) structures formed on a surface of the wafer 400. Each of the dies 402 may be a repeating unit of a semiconductor product that includes any suitable IC (e.g., ICs including one or more structures such as structures such as described above). After the fabrication of the semiconductor product is complete (e.g., after manufacture of structures such as described above), the wafer 400 may undergo a singulation process in which each of the dies 402 is separated from one another to provide discrete "chips" of the semiconductor product. In particular, devices that include TFT as disclosed herein may take the form of the wafer 400 (e.g., not singulated) or the form of the die 402 (e.g., singulated). The die 402 may include one or more transistors and/or supporting circuitry to route electrical signals to the transistors, as well as any other IC components. In some embodiments, the wafer 400 or the die 402 may include a memory device (e.g., a static random access memory (SRAM) device), a logic device (e.g., an AND, OR, NAND, or NOR gate), or any other suitable circuit element. Multiple ones of these devices may be combined on a single die 402. For example, a memory array formed by multiple memory devices may be formed on a same die 402 as a processing device or other logic that is configured to store information in the memory devices or execute instructions stored in the memory array.

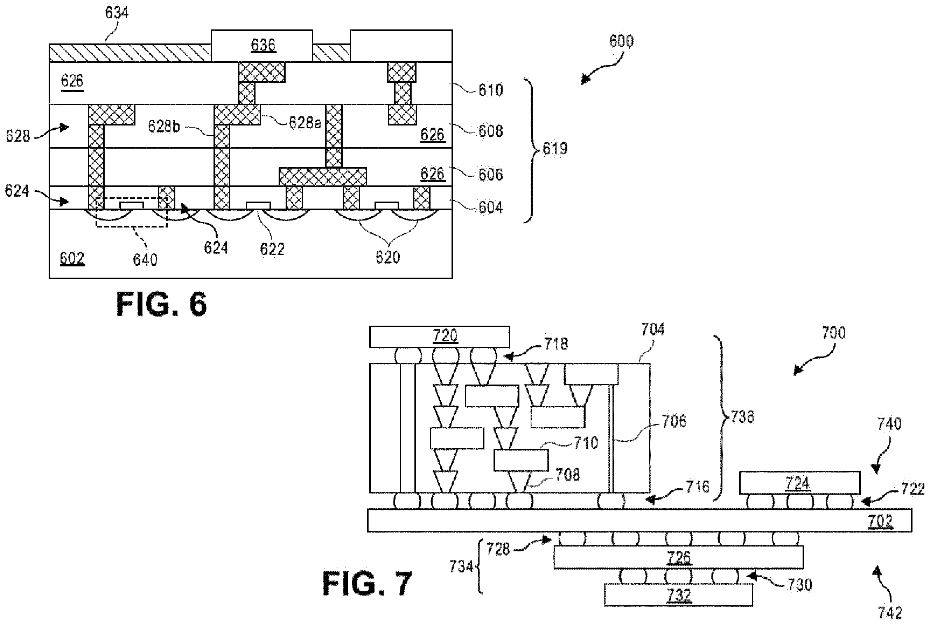

Figure 6 is a cross-sectional side view of an integrated circuit (IC) device that may include one or more thin film transistors having CMOS functionality integrated with two-dimensional (2D) channel materials, in accordance with one or more of the embodiments disclosed herein.

Referring to Figure 6, an IC device 600 is formed on a substrate 602 (e.g., the wafer 400 of Figure 4) and may be included in a die (e.g., the die 402 of Figure 5), which may be singulated or included in a wafer. Although a few examples of materials from which the substrate 602 may be formed are described above, any material that may serve as a foundation for an IC device 600 may be used.

The IC device 600 may include one or more device layers, such as device layer 604, disposed on the substrate 602. The device layer 604 may include features of one or more transistors 640 (e.g., TFTs described above) formed on the substrate 602. The device layer 604 may include, for example, one or more source and/or drain (S/D) regions 620, a gate 622 to control current flow in the transistors 640 between the S/D regions 620, and one or more S/D contacts 624 to route electrical signals to/from the S/D regions 620. The transistors 640 may include additional features not depicted for the sake of clarity, such as device isolation regions, gate contacts, and the like. The transistors 640 are not limited to the type and configuration depicted in Figure 6 and may include a wide variety of other types and configurations such as, for example, planar transistors, non-planar transistors, or a combination of both. Non-planar transistors may include Fin-based transistors, such as double-gate transistors or tri-gate transistors, and wrap-around or all-around gate transistors, such as nanoribbon and nanowire transistors. In particular, one or more of the transistors 640 take the form of the transistors such as described above. Thin-film transistors such as described above may be particularly advantageous when used in the metal layers of a microprocessor device for analog circuitry, logic circuitry, or memory circuitry, and may be formed along with existing complementary metal oxide semiconductor (CMOS) processes.

Electrical signals, such as power and/or input/output (I/O) signals, may be routed to and/or from the transistors 640 of the device layer 604 through one or more interconnect layers disposed on the device layer 604 (illustrated in Figure 6 as interconnect layers 606-610). For example, electrically conductive features of the device layer 604 (e.g., the gate 622 and the S/D contacts 624) may be electrically coupled with the interconnect structures 628 of the interconnect layers 606-610. The one or more interconnect layers 606-610 may form an interlayer dielectric (ILD) stack 619 of the IC device 600.

The interconnect structures 628 may be arranged within the interconnect layers 606-610 to route electrical signals according to a wide variety of designs (in particular, the arrangement is not limited to the particular configuration of interconnect structures 628 depicted in Figure 6). Although a particular number of interconnect layers 606-610 is depicted in Figure 6, embodiments of the present disclosure include IC devices having more or fewer interconnect layers than depicted.

In some embodiments, the interconnect structures 628 may include trench structures 628a (sometimes referred to as "lines") and/or via structures 628b filled with an electrically conductive material such as a metal. The trench structures 628a may be arranged to route electrical signals in a direction of a plane that is substantially parallel with a surface of the substrate 602 upon which the device layer 604 is formed. For example, the trench structures 628a may route electrical signals in a direction in and out of the page from the perspective of Figure 6. The via structures 628b may be arranged to route electrical signals in a direction of a plane that is substantially perpendicular to the surface of the substrate 602 upon which the device layer 604 is formed. In some embodiments, the via structures 628b may electrically couple trench structures 628a of different interconnect layers 606-610 together.

The interconnect layers 606-610 may include a dielectric material 626 disposed between the interconnect structures 628, as shown in Figure 6. In some embodiments, the dielectric material 626 disposed between the interconnect structures 628 in different ones of the interconnect layers 606-610 may have different compositions; in other embodiments, the composition of the dielectric material 626 between different interconnect layers 606-610 may be the same. In either case, such dielectric materials may be referred to as inter-layer dielectric (ILD) materials.

A first interconnect layer 606 (referred to as Metal 1 or "M1") may be formed directly on the device layer 604. In some embodiments, the first interconnect layer 606 may include trench structures 628a and/or via structures 628b, as shown. The trench structures 628a of the first interconnect layer 606 may be coupled with contacts (e.g., the S/D contacts 624) of the device layer 604.

A second interconnect layer 608 (referred to as Metal 2 or "M2") may be formed directly on the first interconnect layer 606. In some embodiments, the second interconnect layer 608 may include via structures 628b to couple the trench structures 628a of the second interconnect layer 608 with the trench structures 628a of the first interconnect layer 606. Although the trench structures 628a and the via structures 628b are structurally delineated with a line within each interconnect layer (e.g., within the second interconnect layer 608) for the sake of clarity, the trench structures 628a and the via structures 628b may be structurally and/or materially contiguous (e.g., simultaneously filled during a dual-damascene process) in some embodiments.

A third interconnect layer 610 (referred to as Metal 3 or "M3") (and additional interconnect layers, as desired) may be formed in succession on the second interconnect layer 608 according to similar techniques and configurations described in connection with the second interconnect layer 608 or the first interconnect layer 606.

The IC device 600 may include a solder resist material 634 (e.g., polyimide or similar material) and one or more bond pads 636 formed on the interconnect layers 606-610. The bond pads 636 may be electrically coupled with the interconnect structures 628 and configured to route the electrical signals of the transistor(s) 640 to other external devices. For example, solder bonds may be formed on the one or more bond pads 636 to mechanically and/or electrically couple a chip including the IC device 600 with another component (e.g., a circuit board). The IC device 600 may have other alternative configurations to route the electrical signals from the interconnect layers 606-610 than depicted in other embodiments. For example, the bond pads 636 may be replaced by or may further include other analogous features (e.g., posts) that route the electrical signals to external components.

Figure 7 is a cross-sectional side view of an integrated circuit (IC) device assembly that may include one or more thin film transistors having CMOS functionality integrated with two-dimensional (2D) channel materials, in accordance with one or more of the embodiments disclosed herein.

Referring to Figure 7, an IC device assembly 700 includes components having one or more integrated circuit structures described herein. The IC device assembly 700 includes a number of components disposed on a circuit board 702 (which may be, e.g., a motherboard). The IC device assembly 700 includes components disposed on a first face 740 of the circuit board 702 and an opposing second face 742 of the circuit board 702. Generally, components may be disposed on one or both faces 740 and 742. In particular, any suitable ones of the components of the IC device assembly 700 may include a number of the TFT structures disclosed herein.

In some embodiments, the circuit board 702 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 702. In other embodiments, the circuit board 702 may be a non-PCB substrate.

The IC device assembly 700 illustrated in Figure 7 includes a package-on-interposer structure 736 coupled to the first face 740 of the circuit board 702 by coupling components 716. The coupling components 716 may electrically and mechanically couple the package-on-interposer structure 736 to the circuit board 702, and may include solder balls (as shown in Figure 7), male and female portions of a socket, an adhesive, an underfill material, and/or any other suitable electrical and/or mechanical coupling structure.

The package-on-interposer structure 736 may include an IC package 720 coupled to an interposer 704 by coupling components 718. The coupling components 718 may take any suitable form for the application, such as the forms discussed above with reference to the coupling components 716. Although a single IC package 720 is shown in Figure 7, multiple IC packages may be coupled to the interposer 704. It is to be appreciated that additional interposers may be coupled to the interposer 704. The interposer 704 may provide an intervening substrate used to bridge the circuit board 702 and the IC package 720. The IC package 720 may be or include, for example, a die (the die 402 of Figure 5), an IC device (e.g., the IC device 600 of Figure 6), or any other suitable component. Generally, the interposer 704 may spread a connection to a wider pitch or reroute a connection to a different connection. For example, the interposer 704 may couple the IC package 720 (e.g., a die) to a ball grid array (BGA) of the coupling components 716 for coupling to the circuit board 702. In the embodiment illustrated in Figure 7, the IC package 720 and the circuit board 702 are attached to opposing sides of the interposer 704. In other embodiments, the IC package 720 and the circuit board 702 may be attached to a same side of the interposer 704. In some embodiments, three or more components may be interconnected by way of the interposer 704.

The interposer 704 may be formed of an epoxy resin, a fiberglass-reinforced epoxy resin, a ceramic material, or a polymer material such as polyimide. In some implementations, the interposer 704 may be formed of alternate rigid or flexible materials that may include the same materials described above for use in a semiconductor substrate, such as silicon, germanium, and other group III-V and group IV materials. The interposer 704 may include metal interconnects 708 and vias 710, including but not limited to through-silicon vias (TSVs) 706. The interposer 704 may further include embedded devices, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio-frequency (RF) devices, power amplifiers, power management devices, antennas, arrays, sensors, and microelectromechanical systems (MEMS) devices may also be formed on the interposer 704. The package-on-interposer structure 736 may take the form of any of the package-on-interposer structures known in the art.

The IC device assembly 700 may include an IC package 724 coupled to the first face 740 of the circuit board 702 by coupling components 722. The coupling components 722 may take the form of any of the embodiments discussed above with reference to the coupling components 716, and the IC package 724 may take the form of any of the embodiments discussed above with reference to the IC package 720.

The IC device assembly 700 illustrated in Figure 7 includes a package-on-package structure 734 coupled to the second face 742 of the circuit board 702 by coupling components 728. The package-on-package structure 734 may include an IC package 726 and an IC package 732 coupled together by coupling components 730 such that the IC package 726 is disposed between the circuit board 702 and the IC package 732. The coupling components 728 and 730 may take the form of any of the embodiments of the coupling components 716 discussed above, and the IC packages 726 and 732 may take the form of any of the embodiments of the IC package 720 discussed above. The package-on-package structure 734 may be configured in accordance with any of the package-on-package structures known in the art.

Embodiments disclosed herein may be used to manufacture a wide variety of different types of integrated circuits and/or microelectronic devices. Examples of such integrated circuits include, but are not limited to, processors, chipset components, graphics processors, digital signal processors, micro-controllers, and the like. In other embodiments, semiconductor memory may be manufactured. Moreover, the integrated circuits or other microelectronic devices may be used in a wide variety of electronic devices known in the arts. For example, in computer systems (e.g., desktop, laptop, server), cellular phones, personal electronics, etc. The integrated circuits may be coupled with a bus and other components in the systems. For example, a processor may be coupled by one or more buses to a memory, a chipset, etc. Each of the processor, the memory, and the chipset, may potentially be manufactured using the approaches disclosed herein.

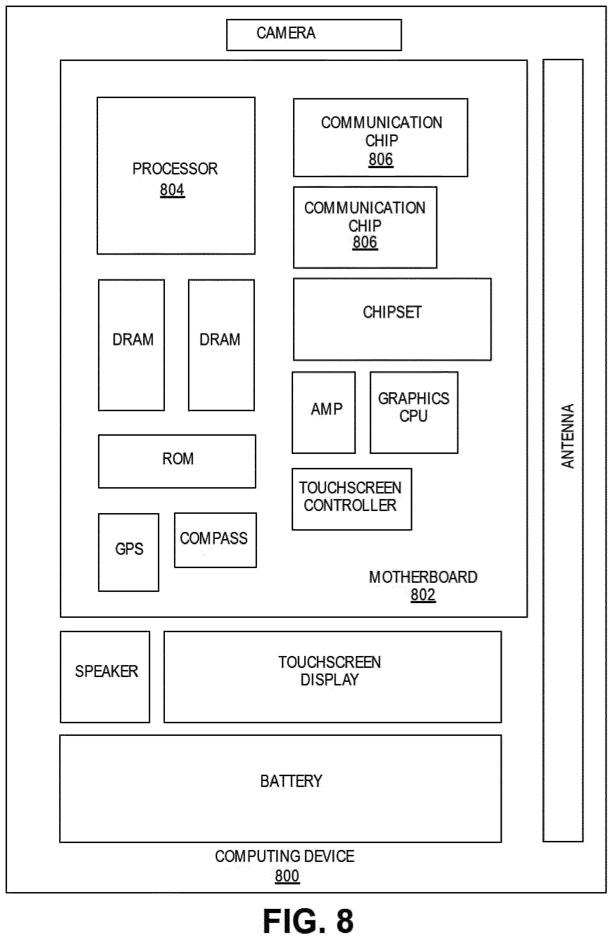

Figure 8 illustrates a computing device 800 in accordance with one implementation of the disclosure. The computing device 800 houses a board 802. The board 802 may include a number of components, including but not limited to a processor 804 and at least one communication chip 806. The processor 804 is physically and electrically coupled to the board 802. In some implementations the at least one communication chip 806 is also physically and electrically coupled to the board 802. In further implementations, the communication chip 806 is part of the processor 804.

Depending on its applications, computing device 800 may include other components that may or may not be physically and electrically coupled to the board 802. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 806 enables wireless communications for the transfer of data to and from the computing device 800. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 806 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 800 may include a plurality of communication chips 806. For instance, a first communication chip 806 may be dedicated to shorter range wireless communications such as Wi-Fi and Bluetooth and a second communication chip 806 may be dedicated to longer range wireless communications such as GPS, EDGE, GPRS, CDMA, WiMAX, LTE, Ev-DO, and others.

The processor 804 of the computing device 800 includes an integrated circuit die packaged within the processor 804. In some implementations of the disclosure, the integrated circuit die of the processor includes one or more thin film transistors having CMOS functionality integrated with two-dimensional (2D) channel materials, in accordance with implementations of embodiments of the disclosure. The term "processor" may refer to any device or portion of a device that processes electronic data from registers and/or memory to transform that electronic data into other electronic data that may be stored in registers and/or memory.

The communication chip 806 also includes an integrated circuit die packaged within the communication chip 806. In accordance with another implementation of embodiments of the disclosure, the integrated circuit die of the communication chip includes one or more thin film transistors having CMOS functionality integrated with two-dimensional (2D) channel materials, in accordance with implementations of embodiments of the disclosure.

In further implementations, another component housed within the computing device 800 may contain an integrated circuit die that includes one or more thin film transistors having CMOS functionality integrated with two-dimensional (2D) channel materials, in accordance with implementations of embodiments of the disclosure.

In various implementations, the computing device 800 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 800 may be any other electronic device that processes data.

Thus, embodiments described herein include thin film transistors having CMOS functionality integrated with two-dimensional (2D) channel materials.

The above description of illustrated implementations of embodiments of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

These modifications may be made to the disclosure in light of the above detailed description. The terms used in the following claims should not be construed to limit the disclosure to the specific implementations disclosed in the specification and the claims. Rather, the scope of the disclosure is to be determined entirely by the following claims, which are to be construed in accordance with established doctrines of claim interpretation.

Example embodiment 1: An integrated circuit structure includes a first device including a first two-dimensional (2D) material layer, and a first gate stack around the first 2D material layer. The first gate stack has a gate electrode around a gate dielectric layer. A second device is stacked on the first device. The second device includes a second 2D material layer, and a second gate stack around the second 2D material layer. The second gate stack has a gate electrode around a gate dielectric layer. The second 2D material layer has a composition different than a composition of the first 2D material layer.

Example embodiment 2: The integrated circuit structure of example embodiment 1, wherein the first device is an NMOS device, and the second device is a PMOS device.

Example embodiment 3: The integrated circuit structure of example embodiment 1, wherein the first device is a PMOS device, and the second device is an NMOS device.

Example embodiment 4: The integrated circuit structure of example embodiment 1, 2 or 3, wherein the first device is electrically coupled to the second device.

Example embodiment 5: The integrated circuit structure of example embodiment 1, 2 or 3, wherein the first device is electrically isolated from the second device.

Example embodiment 6: An integrated circuit structure includes an NMOS device including a first plurality of vertically stacked two-dimensional (2D) material layers, each of the first plurality of vertically stacked 2D material layers including molybdenum and sulfur. A first gate stack is around the first plurality of vertically stacked 2D material layers, the first gate stack having a gate electrode around a gate dielectric layer. A PMOS device is stacked on the NMOS device. The PMOS device includes a second plurality of vertically stacked 2D material layers, each of the second plurality of vertically stacked 2D material layers including tungsten and selenium. A second gate stack is around the second plurality of vertically stacked 2D material layers, the second gate stack having a gate electrode around a gate dielectric layer.

Example embodiment 7: The integrated circuit structure of example embodiment 6, wherein the NMOS device is electrically coupled to the PMOS device.

Example embodiment 8: The integrated circuit structure of example embodiment 6, wherein the NMOS device is electrically isolated from the PMOS device.

Example embodiment 9: The integrated circuit structure of example embodiment 6, 7 or 8, wherein the first plurality of vertically stacked 2D material layers is a first plurality of vertically stacked nanosheets, and the second plurality of vertically stacked 2D material layers is a second plurality of vertically stacked nanosheets.

Example embodiment 10: The integrated circuit structure of example embodiment 6, 7 or 8, wherein the first plurality of vertically stacked 2D material layers is a first plurality of vertically stacked nanowires, and the second plurality of vertically stacked 2D material layers is a second plurality of vertically stacked nanowires.

Example embodiment 11: A computing device includes a board, and a component coupled to the board. The component includes an integrated circuit structure including a first device including a first two-dimensional (2D) material layer, and a first gate stack around the first 2D material layer. The first gate stack has a gate electrode around a gate dielectric layer. A second device is stacked on the first device. The second device includes a second 2D material layer, and a second gate stack around the second 2D material layer. The second gate stack has a gate electrode around a gate dielectric layer. The second 2D material layer has a composition different than a composition of the first 2D material layer.

Example embodiment 12: The computing device of example embodiment 11, further including a memory coupled to the board.

Example embodiment 13: The computing device of example embodiment 11 or 12, further including a communication chip coupled to the board.

Example embodiment 14: The computing device of example embodiment 11, 12 or 13, further including a camera coupled to the board.

Example embodiment 15: The computing device of example embodiment 11, 12, 13 or 14, wherein the component is a packaged integrated circuit die.

Example embodiment 16: A computing device includes a board, and a component coupled to the board. The component includes an integrated circuit structure including an NMOS device including a first plurality of vertically stacked two-dimensional (2D) material layers, each of the first plurality of vertically stacked 2D material layers including molybdenum and sulfur. A first gate stack is around the first plurality of vertically stacked 2D material layers, the first gate stack having a gate electrode around a gate dielectric layer. A PMOS device is stacked on the NMOS device. The PMOS device includes a second plurality of vertically stacked 2D material layers, each of the second plurality of vertically stacked 2D material layers including tungsten and selenium. A second gate stack is around the second plurality of vertically stacked 2D material layers, the second gate stack having a gate electrode around a gate dielectric layer.

Example embodiment 17: The computing device of example embodiment 16, further including a memory coupled to the board.

Example embodiment 18: The computing device of example embodiment 16 or 17, further including a communication chip coupled to the board.

Example embodiment 19: The computing device of example embodiment 16, 17 or 18, further including a camera coupled to the board.

Example embodiment 20: The computing device of example embodiment 16, 17, 18 or 19, wherein the component is a packaged integrated circuit die.

## Claims

1. An integrated circuit structure, comprising:
a first device comprising a first two-dimensional (2D) material layer, and a first gate stack around the first 2D material layer, the first gate stack having a gate electrode around a gate dielectric layer; and
a second device stacked on the first device, the second device comprising a second 2D material layer, and a second gate stack around the second 2D material layer, the second gate stack having a gate electrode around a gate dielectric layer, wherein the second 2D material layer has a composition different than a composition of the first 2D material layer.

2. The integrated circuit structure of claim 1, wherein the first device is an NMOS device, and the second device is a PMOS device.

3. The integrated circuit structure of claim 1, wherein the first device is a PMOS device, and the second device is an NMOS device.

4. The integrated circuit structure of claim 1, 2 or 3, wherein the first device is electrically coupled to the second device.

5. The integrated circuit structure of claim 1, 2 or 3, wherein the first device is electrically isolated from the second device.

6. A method of fabricating an integrated circuit structure, the method comprising:
forming a first device comprising a first two-dimensional (2D) material layer, and a first gate stack around the first 2D material layer, the first gate stack having a gate electrode around a gate dielectric layer; and
forming a second device stacked on the first device, the second device comprising a second 2D material layer, and a second gate stack around the second 2D material layer, the second gate stack having a gate electrode around a gate dielectric layer, wherein the second 2D material layer has a composition different than a composition of the first 2D material layer.

7. The method of claim 6, wherein the first device is an NMOS device, and the second device is a PMOS device.

8. The method of claim 6, wherein the first device is a PMOS device, and the second device is an NMOS device.

9. The method of claim 6, 7 or 8, wherein the first device is electrically coupled to the second device.

10. The method of claim 6, 7 or 8, wherein the first device is electrically isolated from the second device.
